# EUROPÄISCHE PATENTANMELDUNG

(11) **EP 1 746 463 A2**
(43) Veröffentlichungstag der Anmeldung: **24.01.2007**
(21) Anmeldenummer: 06013080.4
(22) Anmeldetag: 24.06.2006
(51) Int. Cl.: G03F 7/20

(54) **Verfahren zum Korrigieren eines lithographischen Projektionsobjektivs und derartiges Projektionsobjektiv**

(30) Priorität: 01.07.2005 US 696118 P
(71) Anmelder: Carl Zeiss SMT AG, 73447 Oberkochen (DE)
(72) Erfinder: Ulrich, Wilhelm, 73434 Aalen (DE); Okon, Thomas, 73431 Aalen (DE); Wabra, Norbert, 97440 Werneck (DE); Gruner, Toralf, Dr., 73433 Aalen-Hofen (DE); Bittner, Boris, 91154 Roth (DE); Gräschus, Volker, 73431 Aalen (DE)
(74) Vertreter: Heuckeroth, Volker

(57) **Zusammenfassung**

Ein Verfahren zum Korrigieren zumindest eines Abbildungsfehlers eines Projektionsobjektivs einer lithographischen Projektionsbelichtungsanlage, das eine optische Anordnung aus einer Mehrzahl an Linsen und zumindest einem Spiegel aufweist, wobei der zumindest eine Spiegel eine optisch wirksame Oberfläche aufweist, die fehlerbehaftet sein kann und somit für den zumindest einen Abbildungsfehler verantwortlich ist, weist die Schritte auf: zumindest näherungsweise Bestimmen eines Verhältnisses VM aus Hauptstrahlhöhe h_{M}H zu Randstrahlhöhe h_{M}R an der optisch wirksamen Oberfläche des zumindest einen Spiegels; zumindest näherungsweise Bestimmen zumindest einer optisch wirksamen Linsenoberfläche unter den Linsenoberflächen der Linsen, an der ein Verhältnis VL aus Hauptstrahlhöhe h_{L}H zu Randstrahlhöhe h_{L}R dem Verhältnis VM dem Betrage nach zumindest am nächsten kommt; Auswählen der zumindest einen bestimmten Linsenoberfläche für die Korrektur des Abbildungsfehlers. Des weiteren wird ein derartiges Projektionsobjektiv beschrieben.

## Beschreibung

### HINTERGRUND DER ERFINDUNG

Die Erfindung betrifft ein Verfahren zum Korrigieren zumindest eines Abbildungsfehlers eines Projektionsobjektivs einer lithographischen Projektionsbelichtungsanlage, wobei das Projektionsobjektiv eine optische Anordnung aus einer Mehrzahl an Linsen und zumindest einem Spiegel aufweist.

Die Erfindung betrifft ferner ein solches Projektionsobjektiv.

Projektionsobjektive der vorstehend genannten Art werden im Rahmen der lithographischen, insbesondere mikrolithographischen Herstellung von Halbleitern verwendet, bei der ein mit einer Struktur versehenes Objekt, das auch als Retikel bezeichnet wird, mittels des Projektionsobjektivs auf einen Träger, der als Wafer bezeichnet wird, abgebildet wird. Der Träger ist mit einer photosensitiven Schicht versehen, bei deren Belichtung mittels Licht durch das Projektionsobjektiv hindurch die Struktur des Objekts auf die photosensitive Schicht übertragen wird. Nach Entwickeln der photosensitiven Schicht entsteht die gewünschte Struktur auf dem Träger, wobei der Belichtungsvorgang unter Umständen mehrfach wiederholt wird.

Ein bei einem solchen Verfahren verwendetes Projektionsobjektiv, das eine optische Anordnung aus einer Mehrzahl an Linsen und zumindest einem Spiegel aufweist, wird auch als katadioptrisch bezeichnet. Ein solches katadioptrisches Projektionsobjektiv ist beispielsweise in dem Dokument WO 2004/019128 A2 beschrieben.

Katadioptrische Projektionsobjektive gewinnen unter den hochaperturigen Projektionsobjektiven immer mehr an Bedeutung, da sie im Vergleich zu rein refraktiven (dioptrischen) Projektionsobjektiven einen wirtschaftlichen Gesamtkompromiss zur Erfüllung der vielfältigen kundenspezifischen Anforderungen ermöglichen.

Der zumindest eine, die häufig mehreren Spiegel solcher katadioptrischen Projektionsobjektive lassen sich in zwei Klassen unterteilen, und zwar solche mit Brechkraft und solche ohne Brechkraft. Die Spiegel mit Brechkraft dienen vorrangig dazu, eine dispersionsfreie Brechkraft und einen geeigneten, meist positiven Beitrag zur Korrektur der Bildschale zu liefern. Hierdurch können im Vergleich zu klassischen, rein refraktiven Designs mehrere Linsen eingespart werden. Spiegel ohne Brechkraft, die auch Faltspiegel genannt werden, dienen der Strahlführung und sind im Allgemeinen aufgrund bauartbedingter Anforderungen erforderlich.

Im Sinne der vorliegenden Erfindung kann der zumindest eine Spiegel ein Spiegel mit oder ohne Brechkraft sein.

Ein Problem katadioptrischer Projektionsobjektive sind die engen Toleranzanforderungen an die optisch wirksamen Oberflächen der Spiegel. Diese engen Toleranzanforderungen haben ihre Ursache darin, dass die optische Wirkung einer Oberflächendeformation eines Spiegels mehr als zweimal größer ist als dies bei der Oberfläche einer Linse der Fall ist. Dies liegt darin begründet, dass eine Deformation Δz eines Spiegels von dem einfallenden und dem reflektierten Lichtstrahl, also doppelt, durchlaufen wird, während eine Oberflächendeformation Δz einer Linsenoberfläche nur einmal durchlaufen wird, und außerdem eine Linse einen Brechungsindex von üblicherweise > 1 besitzt.

Die Oberflächenfehler von Spiegeln können durch Ungenauigkeiten bei der Fertigung oder durch Schichtspannungen der Spiegelbeschichtungen verursacht werden. Fehler können auch durch den Aus- und Einbau von Spiegeln aufgrund einer nicht stets gewährleisteten exakten Reproduzierbarkeit der vorherigen Einbaulage auftreten. Deformationen durch Schichtspannungen ergeben sich häufig daraus, dass die Beschichtung und das Substrat des Spiegels unterschiedliche Wärmeausdehnungskoeffizienten haben, so dass es bei Bestrahlung mit Licht zu einer Formänderung des Spiegels kommt. Ein ähnlicher Effekt kann durch Relaxationsprozesse nach der Beschichtung des Substrats des Spiegels auftreten.

Die Verwendung von Spiegeln in Projektionsobjektiven verlangt demnach einen höheren Justageaufwand, um den vor dem Zusammenbau des Projektionsobjektivs unbekannten Deformationen der verwendeten Spiegel gerecht zu werden.

Fehlerbehaftete Spiegeloberflächen führen zu Wellenfrontfehlern im Projektionslicht und somit zu einer fehlerbehafteten Abbildung des Objekts (Retikel) auf den Träger (Wafer), die angesichts der heutzutage geforderten Miniaturisierung der herzustellenden Halbleiterstrukturen nicht tragbar ist.

Es besteht daher ein Bedürfnis an einem geeigneten Verfahren zum Korrigieren derartiger Wellenfrontfehler bzw. Abbildungsfehler eines katadioptrischen Projektionsobjektivs sowie an einem katadioptrischen Projektionsobjektiv, das zumindest weitgehend fehlerkompensiert ist.

Eine Möglichkeit der Kompensation von Abbildungsfehlern eines katadioptrischen Projektionsobjektivs, die durch einen oder mehrere fehlerbehaftete Spiegel verursacht werden, könnte darin bestehen, die fehlerbehaftete oder die fehlerbehafteten Spiegeloberflächen direkt durch eine lokale Asphärisierung durch Politur oder Ionenstrahlätzen zu korrigieren. Dies stellt sich jedoch mitunter als sehr aufwendig dar, da der fehlerbehaftete oder die fehlerbehafteten Spiegel zur Korrektur unter Umständen mehrmals aus dem Projektionsobjektiv aus- und wieder eingebaut werden müssen, was besonders hohe Anforderungen an die Justage des bzw. der wieder eingebauten Spiegel stellt. Hinzu kommt, dass, wie bereits erwähnt, die optische Wirkung von Defekten von Spiegeln wesentlich größer als die optische Wirkung von Defekten von Linsen ist. Außerdem ist es aufgrund mangelnder Fertigungsgenauigkeit des Asphärisierungsprozesses auf Spiegeloberflächen häufig gar nicht möglich, die Spiegeloberfläche direkt zu korrigieren.

Eine alternative Möglichkeit hierzu besteht darin, eine optisch wirksame Linsenoberfläche in unmittelbarer Nachbarschaft des betroffenen fehlerbehafteten Spiegels zu asphärisieren.

Diese Vorgehensweise ist jedoch nicht bei allen Designs von katadioptrischen Projektionsobjektiven möglich, da nicht immer gewährleistet ist, dass sich Linsen in unmittelbarer Nähe des betreffenden Spiegels befinden, wie dies bei dem Projektionsobjektiv gemäß WO 2002/044786 A2, Fig. 1 der Fall ist. Ferner kann auch der Fall auftreten, dass geeignete Linsen zwar vorhanden sind, diese aber aus bauartbedingten Gründen nicht zur Asphärisierung geeignet sind.

Es besteht daher weiterhin ein Bedürfnis an einem geeigneten Verfahren zum Korrigieren zumindest eines Abbildungsfehlers eines katadioptrischen Projektionsobjektivs sowie an einem fehlerkompensierten katadioptrischen Projektionsobjektiv, dessen Abbildungsfehler durch Defekte in einer oder mehreren Spiegeloberflächen verursacht werden.

### ZUSAMMENFASSENDE DARSTELLUNG DER ERFINDUNG

Es ist eine Aufgabe der vorliegenden Erfindung, ein verbessertes Verfahren zum Korrigieren zumindest eines Abbildungsfehlers eines katadioptrischen Projektionsobjektivs bereitzustellen.

Eine weitere Aufgabe der Erfindung ist es, ein verbessertes katadioptrisches Projektionsobjektiv anzugeben, bei dem Abbildungsfehler, die durch zumindest einen fehlerbehafteten Spiegel verursacht werden, zumindest verringert sind.

Gemäß einem ersten Aspekt der Erfindung wird ein Verfahren zum Korrigieren zumindest eines Abbildungsfehlers eines Projektionsobjektivs einer lithographischen Projektionsbelichtungsanlage bereitgestellt, das eine optische Anordnung aus einer Mehrzahl an Linsen und zumindest einem Spiegel aufweist, wobei der zumindest eine Spiegel eine optisch wirksame Oberfläche aufweist, die fehlerbehaftet sein kann und somit für den zumindest einen Abbildungsfehler verantwortlich ist, mit den Schritten:
zumindest näherungsweise Bestimmen eines Verhältnisses VM aus Hauptstrahlhöhe h_{M}H zu Randstrahlhöhe h_{M}R an der optisch wirksamen Oberfläche des zumindest einen Spiegels,
zumindest näherungsweise Bestimmen zumindest einer optisch wirksamen Linsenoberfläche unter den Linsenoberflächen der Linsen, an der ein Verhältnis VL aus Hauptstrahlhöhe h_{L}H zu Randstrahlhöhe h_{L}R dem Verhältnis VM dem Betrage nach zumindest am nächsten kommt, vorzugsweise Bestimmen dieser optisch wirksamen Linsenoberfläche, so dass zusätzlich VL das gleiche Vorzeichen wie VM hat.

Auswählen der zumindest einen bestimmten Linsenoberfläche für die Korrektur des Abbildungsfehlers.

Gemäß einem weiteren Aspekt der Erfindung wird ein Projektionsobjektiv einer lithographischen Projektionsbelichtungsanlage bereitgestellt, mit einer optischen Anordnung aus einer Mehrzahl an Linsen und zumindest einem Spiegel, wobei der zumindest eine Spiegel eine optisch wirksame Oberfläche aufweist, die zumindest einen Abbildungsfehler der optischen Anordnung hervorrufen kann, wobei für die Korrektur des Abbildungsfehlers zumindest eine optisch wirksame Linsenoberfläche unter den Linsenoberflächen der Linsen ausgewählt ist, an der ein Verhältnis VL aus Hauptstrahlhöhe h_{L}H zu Randstrahlhöhe h_{R}L einem Verhältnis VM aus Hauptstrahlhöhe h_{M}H zu Randstrahlhöhe h_{M}R an der optisch wirksamen Oberfläche des zumindest einen Spiegels dem Betrage nach zumindest am nächsten kommt, vorzugsweise so ausgewählt, dass zusätzlich VL das gleiche Vorzeichen wie VM hat.

Die Erfindung geht von dem Gedanken aus, dass nicht notwendigerweise der Defekt bzw. die Deformation des zumindest einen fehlerbehafteten Spiegels selbst oder in Nähe des Spiegels korrigiert werden muss, sondern dass es ausreicht, deren optische Wirkung zu kompensieren. Diese Kompensation, beispielsweise die optische Wirkung einer Asphärisierung einer optisch wirksamen Fläche, hängt nicht nur von der Form der lokalen Asphärisierung ab, sondern ist auch von der Lage der optischen Fläche in der Projektionsoptik bestimmt. Wesentlich für die Abhängigkeit der optischen Wirkung beispielsweise einer Asphärisierung von der Lage der optischen Fläche in dem Projektionsobjektiv ist das Verhältnis von Hauptstrahl- zu Randstrahlhöhe auf der besagten optischen Fläche. Unter Hauptstrahlhöhe wird die Strahlhöhe des Hauptstrahles eines Feldpunktes des Objektfeldes mit betragsmäßig maximaler Feldhöhe verstanden. Unter Randstrahlhöhe wird die Strahlhöhe eines Strahles mit maximaler Apertur ausgehend von der Feldmitte des Objektfeldes verstanden.

Eine "optisch wirksame Fläche" ist im Sinne der vorliegenden Erfindung allgemein zu verstehen, und eine solche Fläche eines Spiegels kann fokussierend, defokussierend oder lediglich strahlführend (strahlfaltend) sein. Eine optisch wirksame Fläche ist allgemein diejenige Fläche, die im Einbauzustand des Spiegels im Projektionsobjektiv vom Licht genutzt wird.

Die Erfindung beruht darauf, dass für die optimale Auswahl der zur Kompensation des durch eine Deformation des zumindest einen Spiegels verursachten Wellenfrontfehlers vorgesehenen zumindest einen Linsenoberfläche zunächst die Lage des Spiegels innerhalb des Projektionsobjektivs anhand des - vorzeichenbehafteten - Verhältnisses von Hauptstrahl- zu Randstrahlhöhe auf der optisch wirksamen Oberfläche des Spiegels bestimmt wird. Der weitere Schritt besteht dann darin, für die Kompensation bzw. Korrektur des Abbildungsfehlers zumindest eine optisch wirksame Linsenoberfläche unter den Linsenoberflächen der Linsen auszuwählen, an der das Verhältnis aus Hauptstrahlhöhe zu Randstrahlhöhe dem Verhältnis aus Hauptstrahl- zu Randstrahlhöhe an der optisch wirksamen Spiegeloberfläche möglichst nahe kommt oder sogar gleich ist. Mit anderen Worten wird für die Korrektur des Abbildungsfehlers eine zu der fehlerbehafteten Spiegeloberfläche zumindest annähernd konjugierte Linsenoberfläche für die Korrektur ausgewählt, die nicht zwangsläufig dem Spiegel benachbart sein muss.

Die Korrektur des zumindest einen Abbildungsfehlers wird in weiteren bevorzugten Ausgestaltungen der Erfindung durch Versehen der wie zuvor beschrieben ausgewählten zumindest einen Linsenoberfläche mit einer Asphärisierung durchgeführt, oder der zumindest einen Linse, die die ausgewählte Linsenoberfläche aufweist, wird ein Aktuator zugeordnet, so dass der zumindest eine Abbildungsfehler durch eine Lageverstellung, beispielsweise durch Kippen oder Verschieben, oder durch Drehen in einer Ebene senkrecht zur optischen Achse der Linse oder durch eine Kombination dieser Lageverstellungen, korrigiert werden kann und/oder der zumindest einen Linse, die die ausgewählte Linsenoberfläche aufweist, wird ein Aktuator zugeordnet, so dass der zumindest eine Abbildungsfehler durch eine Deformation der Linse korrigiert werden kann.

Weitere Vorteile und Merkmale der Erfindung ergeben sich aus der nachfolgenden Beschreibung bevorzugter Ausführungsbeispiele im Zusammenhang mit der beigefügten Zeichnung.

### KURZE BESCHREIBUNG DER ZEICHNUNG

Ausgewählte Ausführungsbeispiele der Erfindung sind in der Zeichnung dargestellt und werden in Bezug auf diese nachfolgend näher beschrieben. Es zeigen:
Fig. 1 ein katadioptrisches Projektionsobjektiv gemäß einem ersten Ausführungsbeispiel;
Fig. 2 ein katadioptrisches Projektionsobjektiv gemäß einem zweiten Ausführungsbeispiel;
Fig. 3 ein katadioptrisches Projektionsobjektiv gemäß einem dritten Ausführungsbeispiel;
Fig. 4 ein katadioptrisches Projektionsobjektiv gemäß einem vierten Ausführungsbeispiel;
Fig. 5 ein katadioptrisches Projektionsobjektiv gemäß einem fünften Ausführungsbeispiel;
Fig. 6 ein katadioptrisches Projektionsobjektiv gemäß einem sechsten Ausführungsbeispiel; und
Fig. 7 ein katadioptrisches Projektionsobjektiv gemäß einem siebten Ausführungsbeispiel.

### DETAILLIERTE BESCHREIBUNG BEVORZUGTER AUSFÜHRUNGSBEISPIELE

Bevor auf die Figuren näher eingegangen wird, wird zunächst das Verfahren zum Korrigieren zumindest eines Abbildungsfehlers eines katadioptrischen Projektionsobjektivs einer lithographischen Projektionsbelichtungsanlage allgemein beschrieben.

Ein katadioptrisches Projektionsobjektiv weist eine optische Anordnung aus einer Mehrzahl an Linsen und zumindest einem Spiegel auf.

Der zumindest eine Spiegel kann fertigungsbedingt eine defekte, d.h. fehlerbehaftete optisch wirksame Oberfläche aufweisen, die für den zumindest einen Abbildungsfehler verantwortlich ist.

Bei dem Verfahren wird zunächst die Lage der optisch wirksamen Oberfläche des zumindest einen Spiegels innerhalb des Projektionsobjektivs bestimmt.

Diese Bestimmung erfolgt anhand des Verhältnisses VM aus Hauptstrahlhöhe h_{M}H zu Randstrahlhöhe h_{M}R auf der optisch wirksamen Oberfläche des zumindest einen Spiegels.

Unter Hauptstrahlhöhe ist die Strahlhöhe des Hauptstrahles eines Feldpunktes des Objektfeldes mit maximaler Feldhöhe zu verstehen. Unter Randstrahlhöhe ist die Strahlhöhe eines Strahles mit maximaler Apertur ausgehend von der Feldmitte des Objektfeldes zu verstehen.

Nachdem das Verhältnis VM aus Hauptstrahlhöhe h_{M}H zu Randstrahlhöhe h_{M}R an der möglicherweise fehlerbehafteten optisch wirksamen Oberfläche des zumindest einen Spiegels bestimmt ist, wird zumindest eine zu der optisch wirksamen Spiegelfläche zumindest annähernd konjugierte optisch wirksame Linsenoberfläche unter der Gesamtheit der Linsenoberflächen der im Projektionsobjektiv vorhandenen Linsen bestimmt, an der also ein Verhältnis VL aus Hauptstrahlhöhe h_{L}H zu Randstrahlhöhe h_{M}R dem Verhältnis VM dem Betrage nach zumindest nahe kommt, von diesem beispielsweise weniger als 20 %, vorzugsweise weniger als 15 %, weiter vorzugsweise weniger als 10 % abweicht.

Besonders bevorzugt wird die obige zumindest eine zumindest annähernd konjugierte optisch wirksame Linsenoberfläche derart ausgewählt, dass zusätzlich auch das Vorzeichen von VL dem von VM entspricht.

Die Bestimmung des Verhältnisses aus Hauptstrahlhöhe zu Randstrahlhöhe an den einzelnen optisch wirksamen Flächen des Projektionsobjektivs ergibt sich aus den Designdaten des Projektionsobjektivs, wie Linsenkrümmungen, Linsenmaterial, Spiegelkrümmungen, Abstand der optischen Elemente untereinander, Objektposition, Bildebenenposition sowie Apertur- und Feldgröße.

Für die Bestimmung der Lage der optisch wirksamen Oberfläche des zumindest einen Spiegels des Projektionsobjektivs und auch zur Bestimmung der zumindest einen optisch wirksamen Linsenoberfläche für die Korrektur der durch die möglicherweise fehlerbehaftete optisch wirksame Oberfläche des zumindest einen Spiegels verursachten Abbildungsfehler ist es mitunter ausreichend, anstelle einer exakten Bestimmung des Verhältnisses VM bzw. VL zu bestimmen, ob es sich bei den entsprechenden optisch wirksamen Oberflächen um pupillennahe oder feldnahe Flächen handelt.

Hierbei kann eine optisch wirksame Fläche als pupillennah oder gleichbedeutend als in Nähe einer Pupillenebene liegend bezeichnet werden, wenn auf dieser Fläche das Verhältnis V aus Hauptstrahlhöhe zu Randstrahlhöhe dem Betrage nach weniger als 1/n beträgt, und eine optisch wirksame Fläche kann als feldnah oder gleichbedeutend in Nähe einer Feldebene liegend bezeichnet werden, wenn auf dieser Fläche das Verhältnis V aus Hauptstrahlhöhe zu Randstrahlhöhe dem Betrage nach größer als n/10 beträgt. Hierbei ist für den Parameter n der Wert 5, vorzugsweise 10, ganz vorzugsweise 20 zu wählen. Ein optisch wirksames Element wird als pupillennah oder in der Nähe einer Pupillenebene liegend bezeichnet, wenn zumindest eine seiner optisch wirksamen Flächen pupillennah liegt. Ein optisch wirksames Element wird als feldnah oder in der Nähe einer Feldebene liegend bezeichnet, wenn zumindest eine seiner optisch wirksamen Flächen feldnah liegt.

Somit ist es für die Zwecke der Erfindung ausreichend, zunächst die Pupillenebenen und die Feldebenen des Projektionsobjektivs zu bestimmen. Erstere sind zumindest annähernd die Ebenen senkrecht zur optischen Achse, wo annähernd alle Hauptstrahlen von allen Feldpunkten, die nicht auf der der optischen Achse liegen, die optische Achse kreuzen. Das heißt, das obige Verhältnis V aus Hauptstrahlhöhe zu Randstrahlhöhe liegt annähernd bei Null. Letztere sind zumindest annähernd die Ebenen senkrecht zur optischen Achse, wo sich für alle Feldpunkte zumindest annähernd alle zu den jeweiligen Feldpunkten gehörenden Aperturstrahlen vereinigen. Das heißt, das obige Verhältnis V aus Hauptstrahlhöhe zu Randstrahlhöhe liegt - betragsmäßig - annähernd bei Unendlich. Letztere teilen sich in Objektebene, Zwischenbilder und Bildebene auf.

Das Vorzeichen des Verhältnisses V von Hauptstrahlhöhe zu Randstrahlhöhe ändert sich mit jedem Durchgang durch eine Pupillen- oder eine Feldebene.

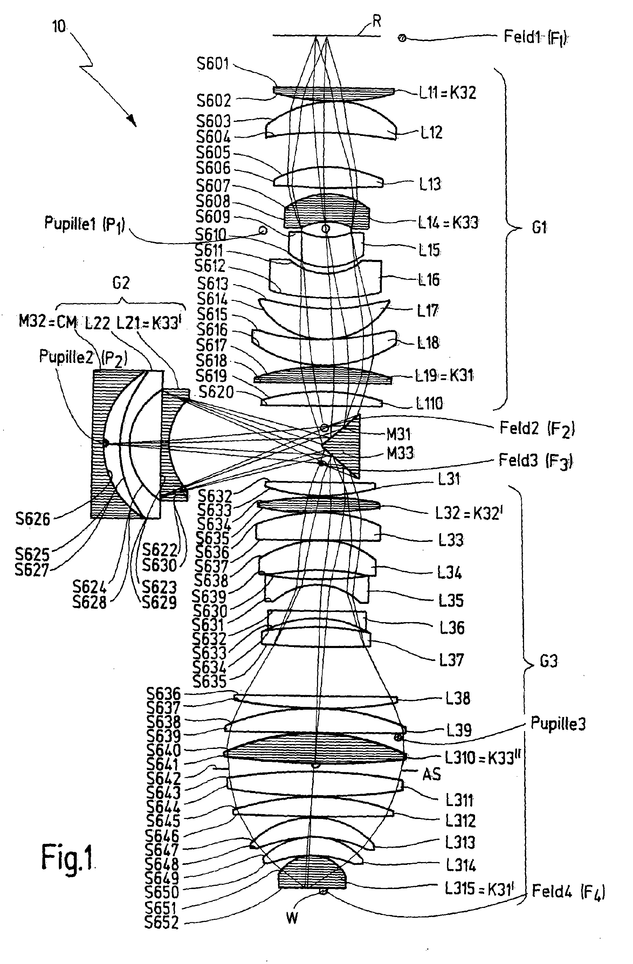

Mit Bezug auf Fig. 1 wird nun ein erstes Ausführungsbeispiel eines Projektionsobjektivs beschrieben, bei dem das erfindungsgemäße Verfahren angewandt wird.

Das Projektionsobjektiv ist in Fig. 1 mit dem allgemeinen Bezugszeichen 10 versehen. Zu einer detaillierten Beschreibung des Projektionsobjektivs 10 wird auf das oben genannte Dokument WO 2004/019128 A2 verwiesen.

Das Projektionsobjektiv 10 weist drei Linsengruppen und drei Spiegel auf, wobei die erste Linsengruppe die Linsen L₁₁ bis L₁₁₀, die zweite Linsengruppe die Linsen L₂₁ und L₂₂ und die dritte Linsengruppe die Linsen L₃₁ bis L₃₁₅ aufweist.

M₃₁ und M₃₃ bezeichnen zwei Faltspiegel, die plan sind, und CM (= M₃₂) bezeichnet einen Hohlspiegel. Mit R ist die Objekt- bzw. Retikelebene, und mit W die Bild- bzw. Waferebene bezeichnet.

Das Projektionsobjektiv 10 in Fig. 1 weist vier Feldebenen F₁ bis F₄ auf, nämlich das Objektfeld F₁, das Feld F₂ zwischen dem Faltspiegel M₃₁ und dem Spiegel CM, nahe dem Faltspiegel M₃₁, ein Feld F₃ zwischen dem Spiegel CM und dem Faltspiegel M₃₃, nahe dem Spiegel M₃₂, und das Bildfeld F₄.

Weiterhin weist das Projektionsobjektiv 10 in Fig. 1 drei Pupillenebenen auf, nämlich eine Pupillenebene P₁ zwischen den Linsen L₁₄ und L₁₅, eine Pupillenebene P₂ auf dem Spiegel CM und eine Pupillenebene P₃ zwischen den Linsen L₃₁₀ und L₃₁₁.

Der Spiegel CM steht somit in der Nähe einer Pupillenebene, in der definitionsgemäß das Verhältnis aus Hauptstrahlhöhe zu Randstrahlhöhe annähernd 0 ist. Seine etwaigen Oberflächendeformationen, die zu Abbildungsfehlern Anlass geben, können durch Auswahl zumindest einer Linsenoberfläche der Linsen L₁₁ bis L₃₁₅ für die Korrektur korrigiert werden, die in Nähe einer der drei Pupillenebenen P₁ bis P₃ angeordnet sind. Als solche Linsenoberflächen kommen bei dem Projektionsobjektiv 10 Folgende bevorzugt in Frage:
die Linsenoberfläche S₆₀₈ der Linse L₁₄,
die Linsenoberfläche S₆₀₉ der Linse L₁₅,
die Linsenoberfläche S_{623, 629} der Linse L₂₁,
die Linsenoberfläche S_{625, 627} der Linse L₂₂,
die Linsenoberfläche S₆₄₁ der Linse L₃₁₀ und/oder
die Linsenoberfläche S₆₄₃ der Linse L₃₁₁.

Demgegenüber stehen die beiden Faltspiegel M₃₁ und M₃₃ in Nähe der Feldebenen F₂ und F₃ und werden durch die Pupillenebene P₂ und die Feldebenen F₂ und F₃ voneinander getrennt. Daraus folgt, dass das Verhältnis h_{M}H/h_{M}R auf den Oberflächen der Spiegel M₃₁ und M₃₃ vom Betrag her vergleichbar, vom Vorzeichen her aber verschieden ist. Daher ist es erforderlich, zumindest zwei weitere optisch wirksame Linsenoberflächen zur Asphärisierung vorzusehen.

Für die Korrektur bzw. Kompensation von Oberflächendeformationen des Faltspiegels M₃₁ kann die Linsenoberfläche S₆₂₀ der Linse L₁₁₀ oder die Linsenoberfläche S₆₁₈ der Linse L₁₉ ausgewählt werden oder die Linsenoberfläche S₆₅₂ der Linse L₃₁₅ ausgewählt werden.

Für die Korrektur bzw. Kompensation von Oberflächendeformationen des Faltspiegels M₃₃ kann die Linsenoberfläche S₆₃₂ der Linse L₃₁ oder die Linsenoberfläche S₆₃₄ der Linse L₃₂ oder auch beispielsweise die Linsenoberfläche S₆₀₁ oder die Linsenoberfläche S₆₀₂ der Linse L₁₁ ausgewählt werden, an denen das Verhältnis aus Hauptstrahlhöhe zu Randstrahlhöhe sowohl seitens des Betrages als auch vom Vorzeichen her geeignet ist.

Wählt man so zur Korrektur einer einzelnen Spiegeloberfläche nur jeweils eine einzelne Linsenoberfläche, so ergeben sich somit zehn Kombinationsmöglichkeiten von Linsenoberflächen, die für die Korrektur von Deformationen der Spiegel M₃₁, M₃₃ und CM ausgewählt werden können. Die Korrektur der durch Deformationen der Spiegel M₃₁, M₃₃ bzw. CM hervorgerufenen Abbildungsfehler kann durch Vorsehen von Asphärisierungen auf den oben genannten ausgewählten Linsenoberflächen bzw. auf einzelnen dieser Linsenoberflächen erfolgen.

Zusätzlich können die zu den oben genannten Linsenoberflächen gehörenden Linsen mit Aktuatoren (nicht dargestellt) versehen sein, so dass diese Linsen leicht lageverstellt werden können, beispielsweise durch Kippen oder Verschieben, oder durch Drehen in einer Ebene senkrecht zur optischen Achse oder durch eine Kombination dieser Lageverstellungen der für die Korrektur ausgewählten Linsen. Weiter kann ein solcher Aktuator auch dergestalt sein, dass er eine Verformung der Linse bewirkt.

Zusammengefasst weist das Projektionsobjektiv 10 gemäß Fig. 1 somit einen Spiegel CM in Nähe einer Pupillenebene P₂ und zwei Spiegel M₃₁, M₃₃ in Nähe von Feldebenen F₂, F₃ des Projektionsobjektivs auf. Auf den Spiegeln M₃₁, M₃₃ haben die Verhältnisse VM₁ und VM₂ verschiedene Vorzeichen. Zur Korrektur von Deformationen des Spiegels CM werden optisch wirksame Linsenoberflächen des Projektionsobjektivs 10 ausgewählt, die in Nähe einer Pupillenebene P₁ bis P₃ angeordnet sind. Zur Korrektur von durch Deformationen der Spiegel M₃₁ und M₃₃ verursachten Abbildungsfehlern werden solche optisch wirksame Linsenoberflächen der Linsen des Projektionsobjektivs 10 ausgewählt, die in Nähe der Feldebenen F₁ bis F₄ des Projektionsobjektivs 10 stehen, wobei die Verhältnisse VL aus Hauptstrahlhöhe zu Randstrahlhöhe auf diesen Linsenoberflächen verschiedene Vorzeichen haben.

In Fig. 1 sind diejenigen Linsen, die als Korrekturlinsen ausgewählt werden können, dunkel hinterlegt und als K₃₁, K_{31'}, K₃₂, K_{32'}, K₃₃, K_{33'} und K_{33''} bezeichnet. Auch in den folgenden Figuren sind die Korrekturlinsen dunkel hinterlegt und mit "K" versehen.

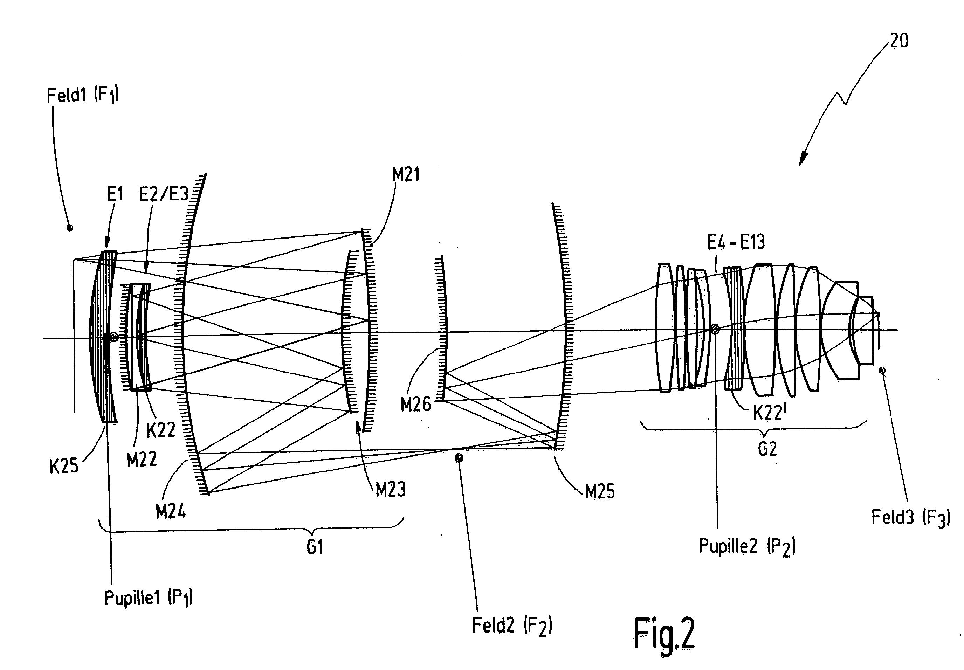

In Fig. 2 ist ein mit dem allgemeinen Bezugszeichen 20 versehenes Projektionsobjektiv dargestellt, das Linsen E₁ bis E₁₃ sowie sechs Spiegel M₂₁ bis M₂₆ aufweist. Für eine detaillierte Beschreibung dieses Projektionsobjektivs 20 wird auf das Dokument WO 02/44786 A2 verwiesen.

Das Projektionsobjektiv 20 weist eine Feldebene F₁ (Objektebene), eine Feldebene F₂ (Zwischenbildebene) und eine Feldebene F₃ (Bildebene) auf. Des Weiteren weist das Projektionsobjektiv 20 eine Pupillenebene P₁ und eine Pupillenebene P₂ auf.

Bei der Bestimmung der Lage der Spiegel M₂₁ bis M₂₆ im Hinblick auf das Verhältnis VM aus Hauptstrahlhöhe h_{M}H zu Randstrahlhöhe h_{M}R an den jeweiligen optisch wirksamen Oberflächen der Spiegel M₂₁ bis M₂₆ ergibt sich daher Folgendes: zumindest der Spiegel M₂₂ ist pupillennah, da er sich in Nähe der Pupillenebene P₁ befindet, und zumindest der Spiegel M₂₅ ist feldnah.

Zur Korrektur bzw. Kompensation von Deformationen und dadurch verursachten Abbildungsfehlern auf der optisch wirksamen Oberfläche des Spiegels M₂₂ kann beispielsweise eine der Linsenoberflächen (oder beide) der Linse K₂₂ (= E₃) bzw. der Linse K_{22'} (= E₈) ausgewählt werden. Für die Korrektur des Spiegels M₂₅ kann beispielsweise die hintere Linsenoberfläche der Linse K₂₅ (= E₁) ausgewählt werden. Zusammenfassend gilt für das Projektionsobjektiv 20, dass der Spiegel M₂₂ pupillennah ist, und dass der Spiegel M₂₅ feldnah ist. Für die Korrektur etwaiger Deformationen auf den vorstehend genannten Spiegeln wird zumindest eine Linsenoberfläche ausgewählt, die in Nähe einer Pupillenebene des Projektionsobjektivs 20 steht, und eine Linsenoberfläche ausgewählt, die in der Nähe einer Feldebene des Projektionsobjektivs 20 steht und deren Verhältnis von Hauptstrahlzu Randstrahlhöhe vom Vorzeichen her dem entsprechenden Verhältnis auf dem Spiegel M₂₅ entspricht. Die Korrektur des Projektionsobjektivs 20 erfolgt wiederum vorzugsweise durch Vorsehen einer Asphärisierung auf den ausgewählten Linsenoberflächen, und/oder durch Zuordnung von Aktuatoren zu den Linsen, die diese Linsenoberflächen aufweisen, so dass die für die Korrektur ausgewählten Linsen verkippt und/oder verschoben und/oder verformt werden können.

Das erfindungsgemäße Verfahren lässt sich auch auf solche Projektionsobjektive anwenden, deren optische Anordnung zumindest zwei Spiegel aufweist, die in Nähe zumindest einer Pupillenebene des Projektionsobjektivs stehen, und an denen die Verhältnisse VM₁ und VM₂ verschiedene Vorzeichen haben, wobei zumindest zwei Linsenoberflächen für die Korrektur ausgewählt werden, die in Nähe zumindest einer Pupillenebene des Projektionsobjektivs 20 angeordnet sind, und an denen die Verhältnisse VL₁ und VL₂ verschiedene Vorzeichen haben.

In gleicher Weise lässt sich das erfindungsgemäße Verfahren auf ein Projektionsobjektiv anwenden, das eine optische Anordnung aus zumindest zwei Spiegeln aufweist, die in Nähe zumindest einer Feldebene des Projektionsobjektivs angeordnet sind, und an denen die Verhältnisse VM₁ und VM₂ gleiche Vorzeichen haben, wobei in diesem Fall zumindest eine Linsenoberfläche für die Korrektur ausgewählt wird, die in Nähe einer Feldebene des Projektionsobjektivs angeordnet ist, und an der das Verhältnis VL das gleiche Vorzeichen hat wie die Verhältnisse VM₁ und VM₂.

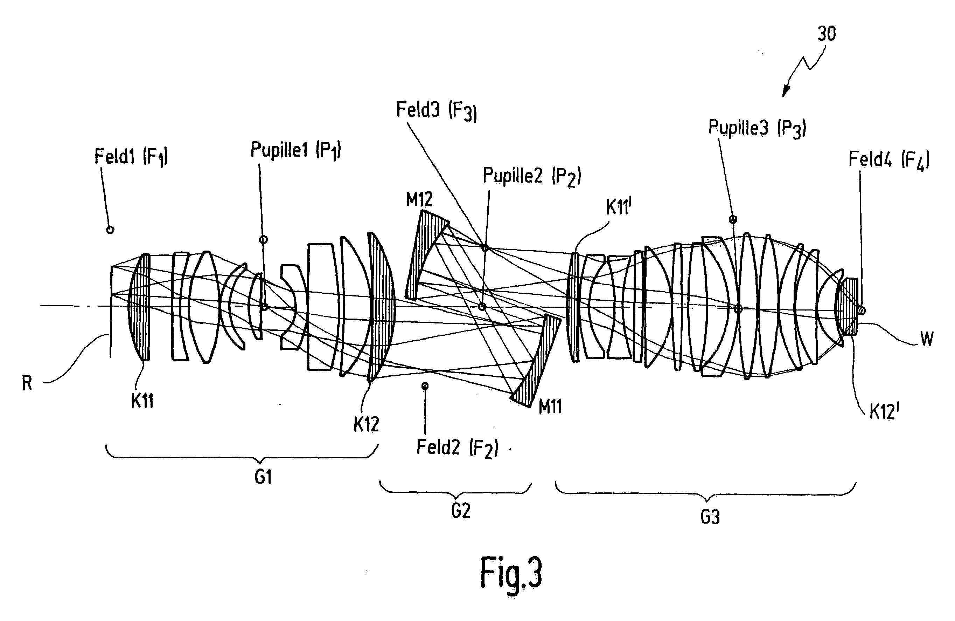

In Fig. 3 ist ein mit dem allgemeinen Bezugszeichen 30 versehenes weiteres Projektionsobjektiv dargestellt.

Das Projektionsobjektiv 30 weist einen ersten, rein dioptrischen Teil G₁ auf, der die Objektebene R via einer ersten Pupillenebene P₁ auf ein erstes Zwischenbild (Feld 2 (F₂)) abbildet. Das Projektionsobjektiv 30 weist weiterhin einen zweiten, katoptrischen Teil G₂ auf, der Spiegel M₁₁ und M₁₂ umfasst, und der das erste Zwischenbild F₂ via einer zweiten Pupillenebene P₂ auf ein zweites Zwischenbild (Feld 3 (F₃)) abbildet. Die beiden Spiegel M₁₁ und M₁₂ sind konkave Spiegel und feldnah angeordnet und befinden sich vor bzw. nach der zweiten Pupillenebene P₂.

Das Projektionsobjektiv 30 weist ferner einen dritten, dioptrischen Teil G₃ auf, der das zweite Zwischenbild F₃ via einer dritten Pupillenebene P₃ auf die Bildebene P₃ auf die Bildebene W abbildet.

Als Korrekturlinse zur Korrektur von Abbildungsfehlern, die durch den Spiegel M₁₁ verursacht sein können, kann die feldnahe Linse K₁₁ vor der ersten Pupillenebene P₁ ausgewählt werden. Zusätzlich oder alternativ hierzu kann zur Korrektur von durch den Spiegel M₁₁ verursachten Abbildungsfehlern die feldnahe Korrekturlinse K₁₁, nach dem zweiten Zwischenbild F₃ und vor der dritten Pupillenebene P₃ hergenommen werden.

Außerdem wird zur Korrektur von Abbildungsfehlern, die durch den Spiegel M₁₂ verursacht werden, die feldnahe Linse K₁₂ nach der ersten Pupillenebene P₁ und vor dem ersten Zwischenbild F₂ und/oder die feldnahe Linse K₁₂, nach der dritten Pupillenebene P₃ verwendet.

Die Linsen K₁₁, K_{11'}, K₁₂, K_{12'} können Linsen mit mindestens einer zur Asphärisierung vorgesehene Oberfläche und/oder in ihrer Position veränderbare Linsen und/oder verformbare Linsen sein.

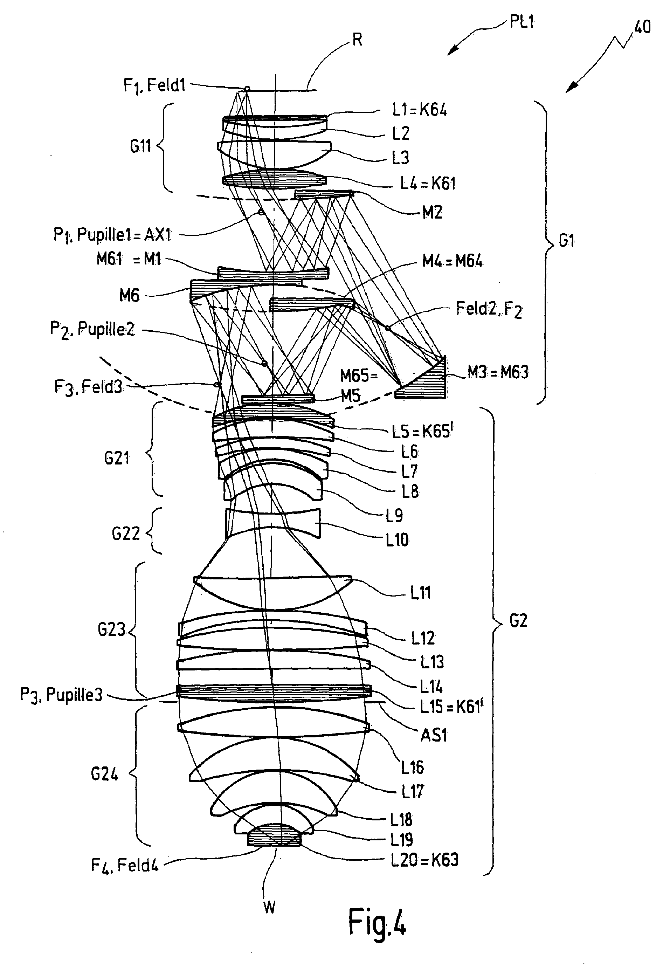

In Fig. 4 ist ein mit dem allgemeinen Bezugszeichen 40 versehenes Projektionsobjektiv dargestellt, das in WO 2004/107011, Fig. 14, hinsichtlich seines prinzipiellen Aufbaus näher beschrieben ist. Insoweit wird auf jenes Dokument verwiesen.

Das Projektionsobjektiv 40 weist in Lichtausbreitungsrichtung einen ersten, katadioptrischen Teil mit Elementen L₁ bis M₆₃ auf, der die Objektebene R via einer ersten Pupillenebene P₁ auf ein erstes Zwischenbild F₂ abbildet, und zumindest einen pupillennahen Spiegel M₆₁ und zumindest einen feldnahen Spiegel M₆₃ nach der ersten Pupillenebene P₁ beinhaltet.

Das Projektionsobjektiv 40 weist des Weiteren einen zweiten, katoptrischen Teil mit Elementen M₆₄ bis M₆₆ auf, der das erste Zwischenbild F₂ via einer zweiten Pupillenebene P₂ auf ein zweites Zwischenbild F₃ abbildet, und zumindest einen feldnahen Spiegel M₆₄ und einen pupillennahen Spiegel M₆₅ beinhaltet.

Schließlich weist das Projektionsobjektiv 40 einen dritten, dioptrischen Teil auf, der Linsen L₅ bis L₂₀ umfasst, und der das zweite Zwischenbild F₃ via einer dritten Pupillenebene P₃ auf das Bild W (Feld 4) abbildet.

Zur "Korrektur des feldnahen Spiegels M₆₃" (was genauer gesagt bedeutet, dass von dem Spiegel M₆₃ verursachte Abbildungsfehler korrigiert werden) ist eine feldnahe Korrekturlinse K₆₃ (= L₂₀) nach der dritten Pupillenebene P₃ vorgesehen, und zur Korrektur des Spiegels M₆₅ ist eine feldnahe Korrekturlinse K₆₅ (= L₁) vor der ersten Pupillenebene P₁ vorgesehen.

Zusätzlich oder alternativ ist zur Korrektur des Spiegels M₆₅ eine feldnahe Korrekturlinse K_{65'} (= L₅) nach dem zweiten Zwischenbild F₃ und vor der dritten Pupillenebene P₃ vorgesehen, und zur Korrektur der Spiegel M₆₁ und M₆₅ ist eine pupillennahe Korrekturlinse K₆₁ (= L₄) in der Nähe der ersten Pupillenebene P₁ vorgesehen, wobei zusätzlich oder alternativ zur Korrektur der Spiegel M₆₁ und M₆₅ eine pupillennahe Korrekturlinse K_{61'} (= L₁₅) in der Nähe der dritten Pupillenebene P₃ vorgesehen sein kann.

Bei den Korrekturlinsen K₆₁ bis K_{65'} handelt es sich um Linsen mit mindestens einer zur Asphärisierung vorgesehenen Oberfläche, und/oder um in ihrer Position veränderbare Linsen, und/oder um verformbare Linsen.

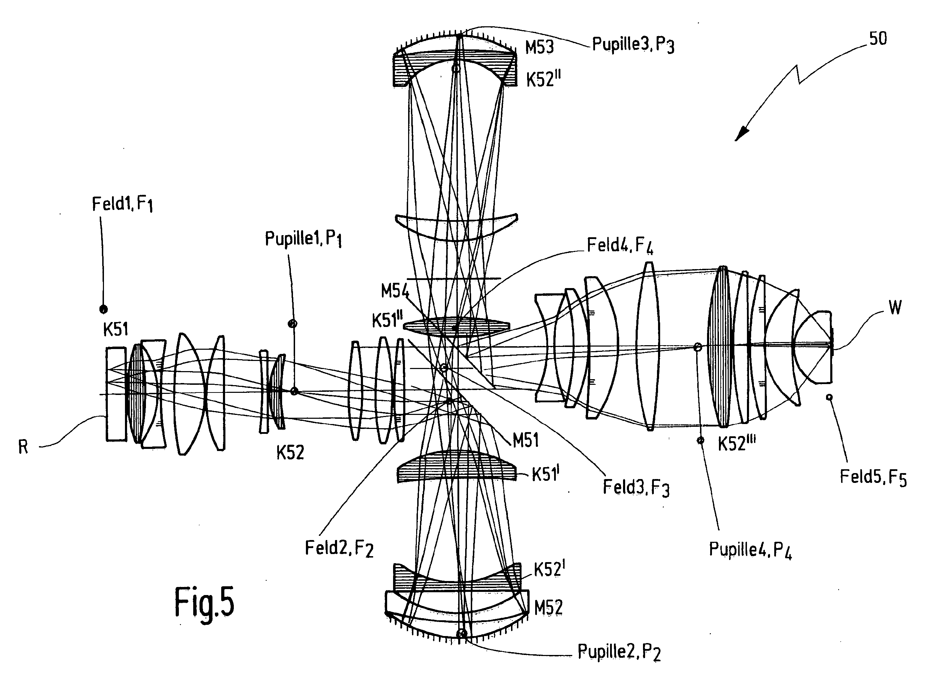

In Fig. 5 ist ein weiteres Projektionsobjektiv dargestellt, das mit dem allgemeinen Bezugszeichen 50 versehen ist.

Das Projektionsobjektiv 50 weist ausgehend von der Objektebene R einen ersten, dioptrischen Teil auf, der die Objektebene R via einer ersten Pupillenebene P₁ auf ein erstes Zwischenbild F₂ abbildet. Das Projektionsobjektiv 50 weist an den ersten, dioptrischen Teil anschließend einen zweiten, katadioptrischen Teil auf, der das erste Zwischenbild F₂ via einer zweiten Bildebene P₂ auf ein zweites Zwischenbild F₃ abbildet, und der zumindest einen feldnahen Spiegel M₅₁ vor der zweiten Pupillenebene P₂ und mindestens einen pupillennahen Spiegel M₅₂ beinhaltet.

Das Projektionsobjektiv 50 weist im weiteren Verlauf einen dritten, katadioptrischen Teil auf, der das zweite Zwischenbild F₃ via einer dritten Pupillenebene P₃ auf ein drittes Zwischenbild F₄ abbildet und einen pupillennahen Spiegel M₅₃ beinhaltet.

Schließlich weist das Projektionsobjektiv 50 einen vierten, katadioptrischen Teil auf, der das dritte Zwischenbild F₄ via einer vierten Pupillenebene P₄ auf die Bildebene W (= F₅) abbildet und einen feldnahen Spiegel M₅₄ vor der vierten Pupillenebene P₄ beinhaltet.

Zur Korrektur der Spiegel M₅₁ und M₅₄ ist eine feldnahe Korrekturlinse K₅₁ vor der ersten Pupillenebene P₁ vorgesehen.

Zusätzlich oder alternativ ist zur Korrektur der Spiegel M₅₁ und M₅₄ eine feldnahe Korrekturlinse K_{51'} nach dem ersten Zwischenbild F₂ und vor der zweiten Pupillenebene P₂ vorgesehen.

Weiter zusätzlich oder alternativ ist zur Korrektur der Spiegel M₅₁ und M₅₄ eine feldnahe Korrekturlinse K_{51''} nach dem zweiten Zwischenbild F₃ und vor der dritten Pupillenebene P₃ vorgesehen.

Zur Korrektur der Spiegel M₅₂ und M₅₃ ist eine pupillennahe Korrekturlinse K₅₂ in der Nähe der ersten Pupillenebene P₁ vorgesehen.

Zusätzlich oder alternativ zur Korrektur der Spiegel M₅₂ und M₅₃ eine pupillennahe Korrekturlinse K_{52'} in der Nähe der zweiten Pupillenebene P₂ vorgesehen.

Weiterhin ist zusätzlich oder alternativ zur Korrektur der Spiegel M₅₂ und M₅₃ eine pupillennahe Korrekturlinse K_{52''} in der Nähe der dritten Pupillenebene P₃ vorgesehen.

Weiter zusätzlich oder alternativ ist zur Korrektur der Spiegel M₅₂ und M₅₃ eine pupillennahe Korrekturlinse K_{52'''} in der Nähe der vierten Pupillenebene P₄ vorgesehen.

Bei den Korrekturlinsen K₅₁ bis K_{52'''} handelt es sich um Linsen mit mindestens einer zur Asphärisierung vorgesehenen Oberfläche, und/oder um in ihrer Position veränderbare Linsen, und/oder um verformbare Linsen.

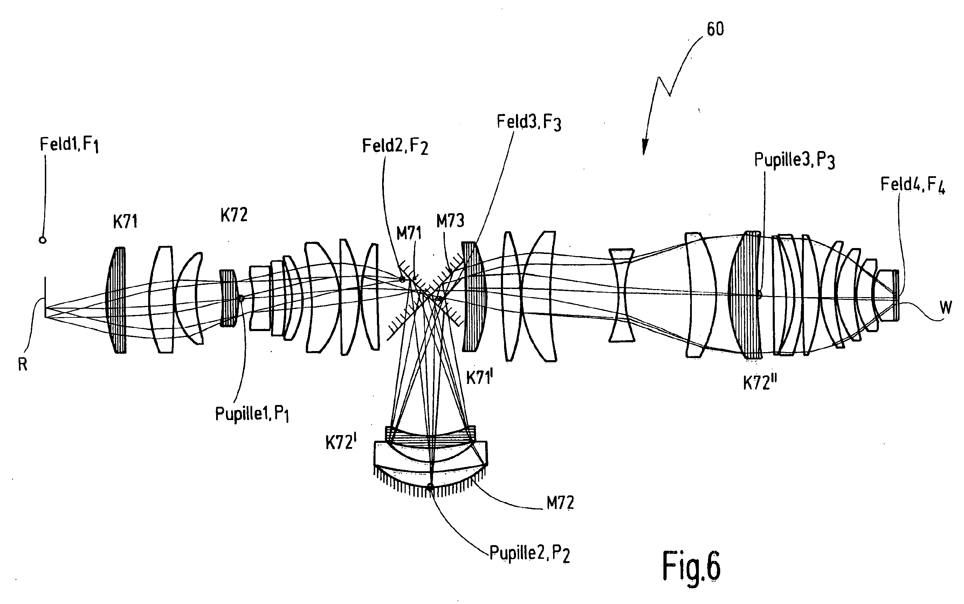

In Fig. 6 ist ein weiteres Projektionsobjektiv dargestellt, das mit dem allgemeinen Bezugszeichen 60 versehen ist. Zur Beschreibung des prinzipiellen Aufbaus dieses Projektionsobjektivs wird auf WO 2004/019128 verwiesen. Das Projektionsobjektiv 60 ist eine Variante des Designs des Projektionsobjektivs 10 in Fig. 1. Entsprechend weist es einen ersten, dioptrischen Teil auf, der die Objektebene via einer ersten Pupillenebene P₁ auf ein erstes Zwischenbild F₂ abbildet. Das Projektionsobjektiv 60 weist weiterhin einen zweiten, katadioptrischen Teil auf, der das erste Zwischenbild F₂ via einer zweiten Pupillenebene P₂ auf ein zweites Zwischenbild F₃ abbildet und einen ersten feldnahen Spiegel M₇₁ vor der zweiten Pupillenebene P₂ und einen pupillennahen Spiegel M₇₂ aufweist. Schließlich weist das Projektionsobjektiv 60 einen dritten katadioptrischen Teil auf, der das zweite Zwischenbild F₃ via einer dritten Pupillenebene P₃ auf das Bild W (F₄) abbildet, und einen zweiten feldnahen Spiegel M₇₃ vor der dritten Pupillenebene P₃ beinhaltet. Die Spiegel M₇₁ und M₇₃ sind wie die Spiegel M₃₁ und M₃₃ Faltspiegel, und der Spiegel M₇₂ ist ein Konkavspiegel.

Zur Korrektur des ersten Spiegels M₇₁ und dritten Spiegels M₇₃ ist eine Korrekturlinse K₇₁ vor der ersten Pupillenebene P₁ vorgesehen. Zusätzlich oder alternativ ist zur Korrektur des Spiegels M₇₁ und des Spiegels M₇₃ eine feldnahe Korrekturlinse K_{71'} nach der zweiten Feldebene F₃ (zweites Zwischenbild) und vor der dritten Pupillenebene P₃ vorgesehen. Zur Korrektur des Spiegels M₇₂ ist eine pupillennahe Linse K₇₂ in der Nähe der ersten Pupillenebene P₁ und/oder eine pupillennahe Linse K_{72'} in der Nähe der zweiten Pupillenebene P₂ und/oder eine pupillennahe Linse K_{72''} in der Nähe der dritten Pupillenebene P₃ vorgesehen.

Die Korrekturlinsen K₇₁ bis K_{72''} können Linsen mit mindestens einer zur Asphärisierung vorgesehenen Oberfläche und/oder in ihrer Position veränderbare Linsen und/oder verformbare Linsen sein.

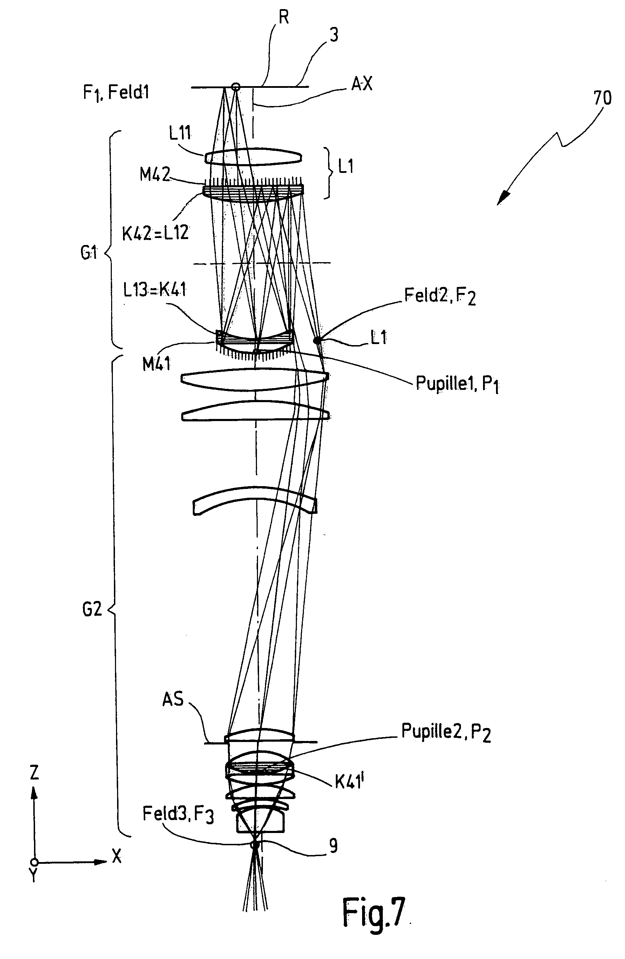

Schließlich ist in Fig. 7 ein mit dem allgemeinen Bezugszeichen 70 versehenes Projektionsobjektiv dargestellt, das in dem Dokument EP 1 318 425 A2 hinsichtlich seines prinzipiellen Aufbaus näher beschrieben ist, worauf insoweit verwiesen wird.

Das Projektionsobjektiv 70 weist einen ersten katadioptrischen Teil mit Elementen L₁₁ bis M₄₂ auf, der die Objektebene R via einer ersten Pupillenebene P₁ auf ein erstes Zwischenbild F₂ abbildet, und zumindest einem pupillennahen Spiegel M₄₁ und zumindest einem feldnahen Spiegel M₄₂ nach der ersten Pupillenebene P₁ aufweist. Das Projektionsobjektiv 70 weist weiterhin einen zweiten, dioptrischen Teil auf, der das Zwischenbild F₂ via einer zweiten Pupillenebene P₂ auf das Bild (Feld 3) abbildet.

Zur Korrektur des Spiegels M₄₁ ist eine pupillennahe Korrekturlinse K₄₁ (= L₁₃) in der Nähe der ersten Pupillenebene P₁ vorgesehen. Alternativ oder zusätzlich ist zur Korrektur des Spiegels M₄₁ eine pupillennahe Korrekturlinse K_{41'} in der Nähe der zweiten Pupillenebene P₂ vorgesehen.

Zur Korrektur des Spiegels M₄₂ ist eine feldnahe Korrekturlinse K₄₂ (= L₁₂) nach der ersten Pupillenebene P₁ und vor dem Zwischenbild F₂ vorgesehen.

Die Korrekturlinsen K₄₁, K_{41'}, K₄₂ können Linsen mit zumindest einer zur Asphärisierung vorgesehenen Oberfläche und/oder in ihrer Position veränderbare Linsen und/oder verformbare Linsen sein.

## Patentansprüche

1. Verfahren zum Korrigieren zumindest eines Abbildungsfehlers eines Projektionsobjektivs einer lithographischen Projektionsbelichtungsanlage, das eine optische Anordnung aus einer Mehrzahl an Linsen und zumindest einem Spiegel aufweist, wobei der zumindest eine Spiegel eine optisch wirksame Oberfläche aufweist, die fehlerbehaftet sein kann und somit für den zumindest einen Abbildungsfehler verantwortlich ist, mit den Schritten:
zumindest näherungsweise Bestimmen eines Verhältnisses VM aus Hauptstrahlhöhe h_{M}H zu Randstrahlhöhe h_{M}R an der optisch wirksamen Oberfläche des zumindest einen Spiegels,
zumindest näherungsweise Bestimmen zumindest einer optisch wirksamen Linsenoberfläche unter den Linsenoberflächen der Linsen, an der ein Verhältnis VL aus Hauptstrahlhöhe h_{L}H zu Randstrahlhöhe h_{L}R dem Verhältnis VM dem Betrage nach zumindest am nächsten kommt,
Auswählen der zumindest einen bestimmten Linsenoberfläche für die Korrektur des Abbildungsfehlers.

2. Verfahren nach Anspruch 1, wobei an der zumindest einen ausgewählten Linsenoberfläche das Verhältnis VL das gleiche Vorzeichen hat wie das Verhältnis VM.

3. Verfahren nach Anspruch 2, wobei der zumindest eine Spiegel in der Nähe einer Feldebene angeordnet ist.

4. Verfahren nach einem der Ansprüche 1 bis 3, wobei die optische Anordnung zumindest einen Spiegel aufweist, der in Nähe einer Pupillenebene des Projektionsobjektivs angeordnet ist, und wobei zumindest eine Linsenoberfläche für die Korrektur ausgewählt wird, die in Nähe einer Pupillenebene des Projektionsobjektivs angeordnet ist.

5. Verfahren nach einem der Ansprüche 1 bis 4, wobei die optische Anordnung zumindest zwei Spiegel aufweist, die in Nähe zumindest einer Feldebene des Projektionsobjektivs angeordnet sind, und an denen die Verhältnisse VM₁ und VM₂ verschiedene Vorzeichen haben, und wobei zumindest zwei Linsenoberflächen für die Korrektur ausgewählt werden, die in Nähe zumindest einer Feldebene des Projektionsobjektivs angeordnet sind, und an denen die Verhältnisse VL₁ und VL₂ unterschiedliche Vorzeichen haben.

6. Verfahren nach einem der Ansprüche 1 bis 5, wobei die optische Anordnung zumindest zwei Spiegel aufweist, die in Nähe zumindest einer Feldebene des Projektionsobjektivs angeordnet sind, und an denen die Verhältnisse VM₁ und VM₂ gleiche Vorzeichen haben, und wobei zumindest eine Linsenoberfläche für die Korrektur ausgewählt wird, die in Nähe einer Feldebene des Projektionsobjektivs angeordnet ist, und an der das Verhältnis VL das gleiche Vorzeichen hat wie die Verhältnisse VM₁ und VM₂.

7. Verfahren nach einem der Ansprüche 1 bis 6, wobei das Verhältnis VL von dem Verhältnis VM weniger als 20 %, vorzugsweise weniger als 15 %, vorzugsweise weniger als 10 % abweicht.

8. Verfahren nach einem der Ansprüche 1 bis 7, wobei die zumindest eine ausgewählte Linsenoberfläche mit einer Asphärisierung zur Korrektur des zumindest einen Abbildungsfehlers versehen wird.

9. Verfahren nach einem der Ansprüche 1 bis 8, wobei der zumindest einen Linse, die die zumindest eine ausgewählte Linsenoberfläche aufweist, ein Aktuator zugeordnet wird, und wobei der Abbildungsfehler durch Lageverstellen und/oder Verformung der zumindest einen Linse mittels des Aktuators korrigiert wird.

10. Projektionsobjektiv einer lithographischen Projektionsbelichtungsanlage, mit einer optischen Anordnung aus einer Mehrzahl an Linsen und zumindest einem Spiegel, wobei der zumindest eine Spiegel eine optisch wirksame Oberfläche aufweist, die zumindest einen Abbildungsfehler der optischen Anordnung hervorrufen kann, wobei für die Korrektur des Abbildungsfehlers zumindest eine optisch wirksame Linsenoberfläche unter den Linsenoberflächen der Linsen ausgewählt ist, an der ein Verhältnis VL aus Hauptstrahlhöhe h_{L}H zu Randstrahlhöhe h_{R}L einem Verhältnis VM aus Hauptstrahlhöhe h_{M}H zu Randstrahlhöhe h_{M}R an der optisch wirksamen Oberfläche des zumindest einen Spiegels dem Betrage nach zumindest am nächsten kommt.

11. Projektionsobjektiv nach Anspruch 10, wobei an der zumindest einen ausgewählten Linsenoberfläche das Verhältnis VL das gleiche Vorzeichen hat wie das Verhältnis VM.

12. Projektionsobjektiv nach Anspruch 10 oder 11, wobei die optische Anordnung zumindest einen Spiegel aufweist, der in Nähe einer Pupillenebene des Projektionsobjektivs angeordnet ist, und wobei zumindest eine Linsenoberfläche für die Korrektur ausgewählt ist, die in einer Pupillenebene des Projektionsobjektivs angeordnet ist.

13. Projektionsobjektiv nach einem der Ansprüche 10 bis 12, wobei die optische Anordnung zumindest zwei Spiegel aufweist, die in Nähe zumindest einer Feldebene des Projektionsobjektivs angeordnet ist, und an denen die Verhältnisse VM₁ und VM₂ verschiedene Vorzeichen haben, und wobei zumindest zwei Linsenoberflächen für die Korrektur ausgewählt sind, die in Nähe zumindest einer Feldebene des Projektionsobjektivs angeordnet sind, und an denen die Verhältnisse VL₁ und VL₂ unterschiedliche Vorzeichen haben.

14. Projektionsobjektiv nach einem der Ansprüche 10 bis 13, wobei die optische Anordnung zumindest zwei Spiegel aufweist, die in Nähe zumindest einer Feldebene des Projektionsobjektivs angeordnet sind, und an denen die Verhältnisse VM₁ und VM₂ gleiche Vorzeichen haben, und wobei zumindest eine Linsenoberfläche für die Korrektur ausgewählt ist, die in Nähe einer Feldebene des Projektionsobjektivs angeordnet ist, und an der das Verhältnis VL das gleiche Vorzeichen hat wie die Verhältnisse VM₁ und VM₂.

15. Projektionsobjektiv nach einem der Ansprüche 10 bis 14, wobei das Verhältnis VL von dem Verhältnis VM weniger als 20 % abweicht, vorzugsweise weniger als 15 %, vorzugsweise weniger als 10 %.

16. Projektionsobjektiv nach einem der Ansprüche 10 bis 15, wobei die zumindest eine ausgewählte Linsenoberfläche mit einer Asphärisierung versehen ist.

17. Projektionsobjektiv nach einem der Ansprüche 10 bis 16, wobei der zumindest einen Linse, die die zumindest eine ausgewählte Linsenoberfläche aufweist, ein Aktuator zur Lageverstellung und/oder Verformung der Linse zugeordnet ist.

18. Projektionsobjektiv, insbesondere nach einem der Ansprüche 10 bis 17, mit, im Sinne des Lichtdurchtritts, folgender Reihenfolge optisch wirksamer Baugruppen:
- ein erster, dioptrischer Teil, der die Objektebene via einer ersten Pupillenebene auf ein erstes Zwischenbild abbildet,
- ein zweiter, katoptrischer Teil, der das erste Zwischenbild via einer zweiten Pupillenebene auf ein zweites Zwischenbild abbildet, und der einen ersten und einen zweiten jeweils feldnahen Konkavspiegel (M₁₁) und (M₁₂) vor bzw. nach der zweiten Pupillenebene beinhaltet,
- ein dritter, dioptrischer Teil, der das zweite Zwischenbild via einer dritten Pupillenebene auf die Bildebene abbildet,
wobei
eine feldnahe, zur Korrektur des ersten Konkavspiegels (M₁₁) vorgesehene Korrekturlinse (K₁₁) vor der ersten Pupillenebene angeordnet ist, und/oder
eine feldnahe, zur Korrektur des ersten Konkavspiegels (M₁₁) vorgesehene Korrekturlinse (K_{11'}) nach dem zweiten Zwischenbild und vor der dritten Pupillenebene angeordnet ist, und
eine feldnahe, zur Korrektur des zweiten Konkavspiegels (M₁₂) vorgesehene Korrekturlinse (K₁₂) nach der ersten Pupillenebene und vor dem ersten Zwischenbild angeordnet ist, und/oder
eine feldnahe, zur Korrektur des zweiten Konkavspiegels (M₁₂) vorgesehene Korrekturlinse (K_{12'}) nach der dritten Pupillenebene angeordnet ist.

19. Projektionsobjektiv, insbesondere nach einem der Ansprüche 10 bis 17, mit, im Sinne des Lichtdurchtritts, folgender Reihenfolge optisch wirksamer Baugruppen:
- ein erster, katadioptrischer Teil, der die Objektebene via einer ersten Pupillenebene auf ein Zwischenbild abbildet, und der eine gerade Anzahl von zumindest zwei Spiegeln (M₂₁ - M₂₄) beinhaltet, von denen zumindest ein erster Spiegel (M₂₂) pupillennah steht,
- ein zweiter, katadioptrischer Teil, der das Zwischenbild via einer zweiten Pupillenebene auf das Bild abbildet, und einen zweiten, feldnahen Spiegel (M₂₅) beinhaltet,
wobei
eine pupillennahe, zur Korrektur des ersten Spiegels (M₂₂) vorgesehene Korrekturlinse (K₂₂) in der Nähe der ersten Pupillenebene vorgesehen ist, und/oder
eine pupillennahe, zur Korrektur des ersten Spiegels (M₂₂) vorgesehene Korrekturlinse (K_{22'}) in der Nähe der zweiten Pupillenebene vorgesehen ist, und
eine feldnahe, zur Korrektur des zweiten Spiegels (M₂₅) vorgesehene Korrekturlinse (K₂₅) vor der ersten Pupillenebene vorgesehen ist.

20. Projektionsobjektiv, insbesondere nach einem der Ansprüche 10 bis 17, mit, im Sinne des Lichtdurchtritts, folgender Reihenfolge optisch wirksamer Baugruppen:
- ein erster, katadioptrischer Teil, der die Objektebene via einer ersten Pupillenebene auf ein erstes Zwischenbild abbildet, und der einen ersten, feldnahen Spiegel (M₃₁) nach der ersten Pupillenebene beinhaltet,
- ein zweiter, katadioptrischer Teil, der das erste Zwischenbild via einer zweiten Pupillenebene auf ein zweites Zwischenbild abbildet, und der einen zweiten, pupillennahen Spiegel (M₃₂) beinhaltet,
- ein dritter katadioptrischer Teil, der das zweite Zwischenbild via einer dritten Pupillenebene auf das Bild abbildet, und der einen dritten, feldnahen Spiegel (M₃₃) vor der dritten Pupillenebene beinhaltet,
wobei
eine feldnahe, zur Korrektur des ersten Spiegels (M₃₁) vorgesehene Korrekturlinse (K₃₁) nach der ersten Pupillenebene und vor dem ersten Zwischenbild vorgesehen ist, und/oder
eine feldnahe, zur Korrektur des ersten Spiegels (M₃₁) vorgesehene Korrekturlinse (K_{31'}) nach der dritten Pupillenebene vorgesehen ist, und
eine feldnahe, zur Korrektur des dritten Spiegels (M₃₃) vorgesehene Korrekturlinse (K₃₂) vor der ersten Pupillenebene vorgesehen ist, und/oder
eine feldnahe, zur Korrektur des dritten Spiegels (M₃₃) vorgesehene Korrekturlinse (K_{32'}) nach dem zweiten Zwischenbild und vor der dritten Pupillenebene vorgesehen ist, und
eine pupillennahe, zur Korrektur des zweiten Spiegels (M₃₂) vorgesehene Korrekturlinse (K₃₃) in der Nähe der ersten Pupillenebene vorgesehen ist, und/oder
eine pupillennahe, zur Korrektur des zweiten Spiegels (M₃₂) vorgesehene Korrekturlinse (K_{33'}) in der Nähe der zweiten Pupillenebene vorgesehen ist, und/oder
eine pupillennahe, zur Korrektur des zweiten Spiegels (M₃₂) vorgesehene Korrekturlinse (K_{33''}) in der Nähe der dritten Pupillenebene vorgesehen ist.

21. Projektionsobjektiv, insbesondere nach einem der Ansprüche 10 bis 17, mit, im Sinne des Lichtdurchtritts, folgender Reihenfolge optisch wirksamer Baugruppen:
- ein erster katadioptrischer Teil, der die Objektebene via einer ersten Pupillenebene auf ein erstes Zwischenbild abbildet, und der einen ersten, pupillennahen Spiegel (M₄₁) und einen zweiten, feldnahen Spiegel (M₄₂) beinhaltet, wobei Letzterer nach der ersten Pupillenebene angeordnet ist,
- ein zweiter, dioptrischer Teil, der das Zwischenbild via einer zweiten Pupillenebene auf das Bild abbildet,
wobei
eine pupillennahe, zur Korrektur des ersten Spiegels (M₄₁) vorgesehene Korrekturlinse (K₄₁) in der Nähe der ersten Pupillenebene vorgesehen ist, und/oder
eine pupillennahe, zur Korrektur des ersten Spiegels (M₄₁) vorgesehene Korrekturlinse (K_{41'}) in der Nähe der zweiten Pupillenebene vorgesehen ist, und
eine feldnahe, zur Korrektur des zweiten Spiegels (M₄₂) vorgesehene Korrekturlinse (K₄₂) nach der ersten Pupillenebene und vor dem Zwischenbild vorgesehen ist.

22. Projektionsobjektiv, insbesondere nach einem der Ansprüche 10 bis 17, mit, im Sinne des Lichtdurchtritts, folgender Reihenfolge optisch wirksamer Baugruppen:
- ein erster, dioptrischer Teil, der die Objektebene via einer ersten Pupillenebene auf ein erstes Zwischenbild abbildet,
- ein zweiter, katadioptrischer Teil, der das erste Zwischenbild via einer zweiten Pupillenebene auf ein zweites Zwischenbild abbildet, und der einen ersten, feldnahen Spiegel (M₅₁) vor der zweiten Pupillenebene und einen zweiten, pupillennahen Spiegel (M₅₂) beinhaltet,
- ein dritter, katadioptrischer Teil, der das zweite Zwischenbild via einer dritten Pupillenebene auf ein drittes Zwischenbild abbildet, und der einen dritten, pupillennahen Spiegel (M₅₃) beinhaltet,
- ein vierter, katadioptrischer Teil, der das dritte Zwischenbild via einer vierten Pupillenebene auf das Bild abbildet, und der einen vierten, feldnahen Spiegel (M₅₄) vor der vierten Pupillenebene beinhaltet,
wobei
eine feldnahe, zur Korrektur des ersten und vierten Spiegels (M₅₁, M₅₄) vorgesehene Korrekturlinse (K₅₁) vor der ersten Pupillenebene vorgesehen ist, und/oder
eine feldnahe, zur Korrektur des ersten und vierten Spiegels (M₅₁, M₅₄) vorgesehene Korrekturlinse (K_{51'}) nach dem ersten Zwischenbild vor der zweiten Pupillenebene vorgesehen ist, und/oder
eine feldnahe, zur Korrektur des ersten und vierten Spiegels (M₅₁, M₅₄) vorgesehene Korrekturlinse (K_{51''}) nach dem zweiten Zwischenbild und vor der dritten Pupillenebene vorgesehen ist, und
eine pupillennahe, zur Korrektur des zweiten und dritten Spiegels (M₅₂, M₅₃) vorgesehene Korrekturlinse (K₅₂) in der Nähe der ersten Pupillenebene vorgesehen ist, und/oder
eine pupillennahe, zur Korrektur des zweiten und dritten Spiegels (M₅₂, M₅₃) vorgesehene Korrekturlinse (K_{52'}) in der Nähe der zweiten Pupillenebene vorgesehen ist, und/oder
eine pupillennahe, zur Korrektur des zweiten und dritten Spiegels (M₅₂, M₅₃) vorgesehene Korrekturlinse (K_{52''}) in der Nähe der dritten Pupillenebene vorgesehen ist, und/oder
eine pupillennahe, zur Korrektur des zweiten und dritten Spiegels (M₅₂, M₅₃) vorgesehene Korrekturlinse (K_{52'''}) in der Nähe der vierten Pupillenebene vorgesehen ist.

23. Projektionsobjektiv, insbesondere nach einem der Ansprüche 10 bis 17, mit, im Sinne des Lichtdurchtritts, folgender Reihenfolge optisch wirksamer Baugruppen:
- ein erster, katadioptrischer Teil, der die Objektebene via einer ersten Pupillenebene auf ein erstes Zwischenbild abbildet, und der einen ersten, pupillennahen Spiegel (M₆₁) und zumindest einen zweiten, feldnahen Spiegel (M₆₃) beinhaltet,
wobei Letzterer nach der ersten Pupillenebene angeordnet ist,
- ein zweiter, katoptrischer Teil, der das erste Zwischenbild via einer zweiten Pupillenebene auf ein zweites Zwischenbild abbildet, und der einen dritten, feldnahen Spiegel (M₆₄) vor der zweiten Pupillenebene und einen vierten, pupillennahen Spiegel (M₆₅) beinhaltet,
- ein dritter, dioptrischer Teil, der das zweite Zwischenbild via einer dritten Pupillenebene auf das Bild abbildet,
wobei
eine feldnahe, zur Korrektur des zweiten Spiegels (M₆₃) vorgesehene Korrekturlinse (K₆₃) nach der dritten Pupillenebene vorgesehen ist, und
eine feldnahe, zur Korrektur des dritten Spiegels (M₆₄) vorgesehene Korrekturlinse (K₆₄) vor der ersten Pupillenebene vorgesehen ist, und/oder
eine feldnahe, zur Korrektur des dritten Spiegels (M₆₄) vorgesehene Korrekturlinse (K_{64'}) nach dem zweiten Zwischenbild und vor der dritten Pupillenebene vorgesehen ist, und
eine pupillennahe, zur Korrektur der Spiegel (M₆₁, M₆₅) vorgesehene Korrekturlinse (K₆₁) in der Nähe der ersten Pupillenebene vorgesehen ist, und/oder
eine pupillennahe, zur Korrektur der Spiegel (M₆₁, M₆₅) vorgesehene Korrekturlinse (K_{61'}) in der Nähe der dritten Pupillenebene vorgesehen ist.

24. Projektionsobjektiv, insbesondere nach einem der Ansprüche 10 bis 17, mit, im Sinne des Lichtdurchtritts, folgender Reihenfolge optisch wirksamer Baugruppen:
- ein erster, dioptrischer Teil, der die Objektebene via einer ersten Pupillenebene auf ein erstes Zwischenbild abbildet,
- ein zweiter, katadioptrischer Teil, der das erste Zwischenbild via einer zweiten Pupillenebene auf ein zweites Zwischenbild abbildet, und der einen ersten feldnahen Spiegel (M₇₁) vor der zweiten Pupillenebene sowie einen pupillennahen Spiegel (M₇₂) beinhaltet,
- ein dritter, katadioptrischer Teil, der das zweite Zwischenbild via einer dritten Pupillenebene auf das Bild abbildet, und der einen zweiten feldnahen Spiegel (M₇₃) vor der dritten Pupillenebene beinhaltet,
wobei
eine feldnahe, zur Korrektur des ersten und dritten Spiegels (M₇₁, M₇₃) vorgesehene Korrekturlinse (K₇₁) vor der ersten Pupillenebene vorgesehen ist, und/oder
eine feldnahe, zur Korrektur des ersten und dritten Spiegels (M₇₁, M₇₃) vorgesehene Korrekturlinse (K_{71'}) nach dem zweiten Zwischenbild und vor der dritten Pupillenebene vorgesehen ist, und
eine pupillennahe, zur Korrektur des zweiten Spiegels (M₇₂) vorgesehene Korrekturlinse (K₇₂) in der Nähe der ersten Pupillenebene vorgesehen ist, und/oder
eine pupillennahe, zur Korrektur des zweiten Spiegels (M₇₂) vorgesehene Korrekturlinse (K_{72'}) in der Nähe der zweiten Pupillenebene vorgesehen ist, und/oder
eine pupillennahe, zur Korrektur des zweiten Spiegels (M₇₂) vorgesehene Korrekturlinse (K_{72''}) in der Nähe der dritten Pupillenebene vorgesehen ist.
